# EUROPÄISCHE PATENTSCHRIFT

(11) **EP 1 098 200 B1**
(45) Veröffentlichungstag und Bekanntmachung des Hinweises auf die Patenterteilung: **06.07.2005**
(21) Anmeldenummer: 00123270.1
(22) Anmeldetag: 26.10.2000
(51) Int. Cl.: G01R 1/073

(54) **Nadelkarten-Justageeinrichtung zur Planarisierung von Nadelsätzen einer Nadelkarte**
Adjusting device for the planarization of probe sets of a probe card
Dispositif de réglage pour la planarisation de jeux de pointes d'une carte à pointes

(30) Priorität: 03.11.1999 DE 19952943
(43) Veröffentlichungstag der Anmeldung: 09.05.2001
(73) Patentinhaber: Infineon Technologies AG, 81669 München (DE)
(72) Erfinder: Kund, Michael, Dr., 81371 München (DE)
(74) Vertreter: Müller - Hoffmann & Partner

(56) Entgegenhaltungen:
- DE-A- 2 544 735
- DE-A- 19 648 475
- GB-A- 2 014 315
- US-A- 5 191 708
- US-A- 5 410 259
- US-A- 5 804 983
- US-A- 5 861 759
- US-A- 5 974 662

## Beschreibung

Die vorliegende Erfindung betrifft eine Nadelkarten-Justageeinrichtung zur Planarisierung von Nadelsätzen einer Nadelkarte (auch als Sondenkarte bezeichnet) in bezug auf einen zu kontaktierenden Wafer, bei der die Nadelkarte mit einer als Kontakt-Schnittstelle zu einem Testkopf dienenden Platine verbunden ist.

Aus der DE 25 44 735 A1 ist ein Prüfkopfträger bekannt, mit dessen Hilfe der Abstand zwischen einzelnen Prufköpfen, die Prüfspitzen tragen, eingestellt werden kann. Damit soll eine Anpassung der Prüfköpfe an verschiedene Schrumpfungen keramischer Substrate erreicht werden.

Weiterhin beschreibt die US 5,861,859 ein automatisches Planarisierungssystem für Prüfkarten, bei dem eine Prüfkarte bezüglich einer Waferoberfläche justiert wird, indem zuerst drei Spitzen der Prüfkarte, von denen zwei höhenvariabel sind, an der Waferoberfläche ausgerichtet werden.

In US-A-5 191 708 ist ein Verfahren zur Herstellung eines Sondenkopfes für ein Halbleiter-LSI-überwachungsgerät beschrieben. Von einer Sondenkarte gehen über ein Verdrahtungssubstrat Sonden ab.

Nadelsätze von Nadelkarten stellen bekanntlich die elektrische Verbindung zwischen einzelnen Kontaktpads bzw. -kissen von Chips einerseits und einem Testkopf her, um so die Funktionsfähigkeit der Chips auf dem Wafer zu überprüfen. Dabei ist die Planarisierung der Nadelsätze der Nadelkarte in bezug auf den zu kontaktierenden Wafer bzw. die in diesem enthaltenen Chips mit zunehmender Anzahl der gleichzeitig zu kontaktierenden Chips immer aufwendiger. Die Nadelsätze müssen nämlich bis in die Größenordnung von 1/4 µm genau auf die ihnen jeweils zugeordneten Kontaktpads der Chips justiert werden.

Dabei ist zu beachten, daß zusätzlich zu der statischen Justage der Nadelkarte relativ zu den Chips auch noch dynamische Komponenten berücksichtigt werden müssen, die beispielsweise durch Wärmeausdehnung der Nadelkarte während eines Aufwärmens bzw. Abkühlens über eine Wafer-Haltevorrichtung, auch "Chuck" genannt, bedingt sind. Andere dynamische Komponenten sind auf Alterungseffekte der Nadelkarten zurückzuführen, auf denen die Nadelsätze meistens verklebt sind. Die dynamischen Komponenten können aber auch sehr kurze Zeitkonstanten, wie beispielsweise bei Erschütterungen, haben.

Bei auf der Nadelkarte verklebten Nadelsätzen werden diese bisher nicht oder nur durch nachträgliches Verbiegen jeder einzelnen Nadel justiert, was bei der geforderten Genauigkeit bis zu 1/4 µm einen erheblichen Kosten- und Zeitaufwand bedeutet. Sind die Nadelsätze auf sogenannten Spacetransformern aufgebracht, so können sie mit Hilfe von einfachen Schrauben justiert werden, womit aber die angegebene Genauigkeit kaum zu erreichen ist.

Es ist daher Aufgabe der vorliegenden Erfindung, eine Nadelkarten-Justageeinrichtung zu schaffen, mit der die Nadelsätze einer Nadelkarte ohne weiteres in bezug auf einen zu kontaktierenden Wafer planarisiert werden können.

Diese Aufgabe wird bei einer Nadelkarten-Justageeinrichtung der eingangs genannten Art erfindungsgemäß dadurch gelöst, daß die Nadelkarte über eine gesonderte, dynamisch arbeitende Justageeinheit mit der Platine verbunden ist und daß die Justageeinheit über eine Sense-Leitung und eine Aktivleitung mit einer Steuereinheit verbunden sind. In bevorzugter Weise ist diese Justageeinheit aus wenigstens einem Piezoelement aufgebaut. Sie kann aber auch eine Vielzahl von Piezoelementen umfassen, die im Randbereich der Nadelkarte an dieser angreifen.

Mit der erfindungsgemäßen Nadelkarten-Justageeinrichtung kann die Planarität der Nadelkarte ohne weiteres an Ort und Stelle durch dynamische Justage hergestellt werden. Das heißt, eine Nadelkarten-Dejustage, die beispielsweise durch Wärmeausdehnung der Nadelkarte oder durch kurzzeitige Erschütterung hervorgerufen ist, läßt sich ohne weiteres korrigieren. Infolge der dynamischen Einstellbarkeit der Nadelkarte laßt sich die Parallelität zwischen Nadelkarte und Wafer bei dessen Kontaktierung über den Waferrand hinaus korrigieren.

Da mit der gesonderten, dynamisch arbeitenden Justageeinheit, über die die Nadelkarte mit der Platine verbunden ist, ohne weiteres auch dynamische Effekte korrigierbar sind, entfällt jeglicher Bedarf für zusätzliche Einstelleinrichtungen. Auch kann mit Hilfe einer Kontakttestschleife, d.h. einem Programm zur Verifikation des Kontaktes jeder Nadel zu einem zugehörigen Pad, die Justage vorgenommen werden.

Die Justageeinheit kann in Richtungen, die im wesentlichen senkrecht zu der durch die Nadelkarten-Oberfläche aufgespannten Ebene sind, und/oder in Richtungen, die im wesentlichen in dieser Ebene liegen, wirken.

Durch den Aufbau der Justageeinheit aus insbesondere Piezoelementen laßt sich deren Einstellbarkeit mit hoher Präzision realisieren.

Nachfolgend wird die Erfindung anhand der Zeichnungen näher erläutert. Es zeigen:
- Fig. 1: eine schematische Seitenansicht einer Nadelkarten-Justageeinrichtung nach einem ersten Ausführungsbeispiel der Erfindung,
- Fig. 2: eine schematische Darstellung einer Nadel, die ein Pad auf einem Chip kontaktiert,
- Fig. 3: eine schematische Seitenansicht einer Nadelkarten-Justageeinheit nach einem zweiten Ausführungsbeispiel der Erfindung und
- Fig. 4: eine Draufsicht auf mehrere Nadelkartensätze in einer Nadelkarten-Justageeinheit nach einem vierten Ausführungsbeispiel der Erfindung.

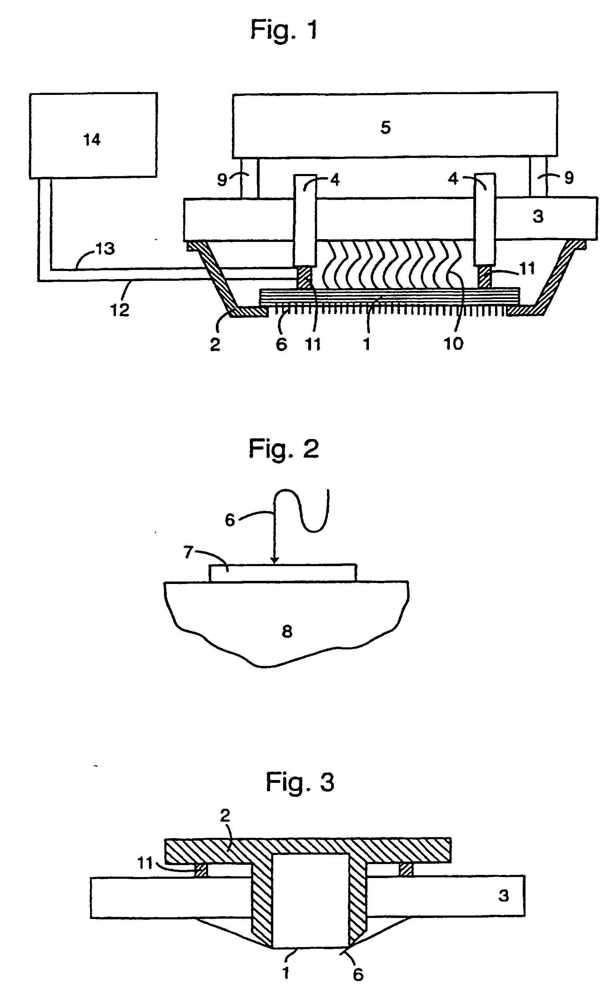

Fig. 1 zeigt eine Nadelkarte 1, die mittels Schrauben 4 zwischen einer Platine 3 und einem Fenster einer Versteifung 2 gelagert ist. Die Platine 3 dient dabei als Kontakt-Schnittstelle zu einem Testkopf 5, mit dessen Hilfe Testsignale zu einzelnen Nadeln 6 der Nadelkarte 1 geliefert werden können.

Fig. 2 zeigt den Aufbau einer solchen Nadel 6, wobei hier die Nadel 6 ein Pad 7 auf einem Chip 8 eines Wafers kontaktiert.

Die elektrische Verbindung zwischen dem Testkopf 5 und der Platine 3 ist durch Verbindungsbusse 9 angedeutet, während zwischen der Platine 3 und den einzelnen Nadeln 6 Verbindungsdrähte 10 geführt sind.

Die Schrauben 4 stellen eine mechanische Justageeinheit dar, da durch deren Verdrehen Parallelität zwischen der Nadelkarte 1 und der Oberfläche eines durch die Nadeln 6 kontaktierten Chips näherungsweise bewirkt werden kann.

Erfindungsgemäß sind zusätzlich zu den Schrauben 4 noch Piezoelemente 11 vorgesehen, die jeweils über eine Fühler- bzw. Sense-Leitung 12 und eine Aktivleitung 13 mit einer Steuereinheit 14 verbunden sind. Wird durch die Piezoelemente 11 eine Fehlausrichtung zwischen den Nadeln 6 der Nadelkarte 1 und der Waferoberfläche festgestellt, so wird diese Fehlausrichtung über die Sense-Leitung 12 an den Rechner 14 gemeldet. In diesem werden die zum Ausgleich der Fehlausrichtung notwendigen Korrekturen berechnet, um sodann entsprechende Signale über die Aktivleitung 13 an die Piezoelemente 11 abzugeben.

Selbstverständlich sind alle Piezoelemente 11 über entsprechende Leitungen 12, 13 mit der Steuereinheit 14 verbunden, obwohl dies in Fig. 1 zur besseren Übersichtlichkeit nur für ein Piezoelement 11 gezeigt ist.

Anstelle von Piezoelementen können auch andere, eine dynamische Justage ermöglichende Bauteile verwendet werden.

Die Leitungen 12, 13 bilden mit der Steuereinheit 14 eine Kontakttestschleife, mit deren Hilfe durch entsprechende Dillatation bzw. Kontraktion der Piezoelemente 11 die gewünschte Justage vorgenommen werden kann.

Die Nullposition der Nadelkarte kann nach einer durchgeführten Justage mittels der Schrauben 4 eingestellt werden, so daß die Piezoelemente 11 nur noch Nachjustierungen vorzunehmen brauchen.

Fig. 3 zeigt ein weiteres Ausführungsbeispiel der Erfindung, bei dem die Nadelkarte 1 mit einem Satz aus Nadeln 6 in einem Fenster einer Versteifung 2 gelegen ist. Hier sind die Piezoelemente 11 zwischen dieser Versteifung 2 und einer Platine 3 angeordnet, so daß die Justage allein über die Piezoelemente 3 und nicht über zusätzliche Schrauben 4 vorzunehmen ist.

Im übrigen ist das Ausführungsbeispiel der Fig. 3 in gleicher Weise wie das Ausführungsbeispiel der Fig. 1 aufgebaut: auch hier sind die Piezoelemente 11 über entsprechende Leitungen (in Fig. 3 nicht gesondert gezeigt) mit einer Steuereinheit verbunden.

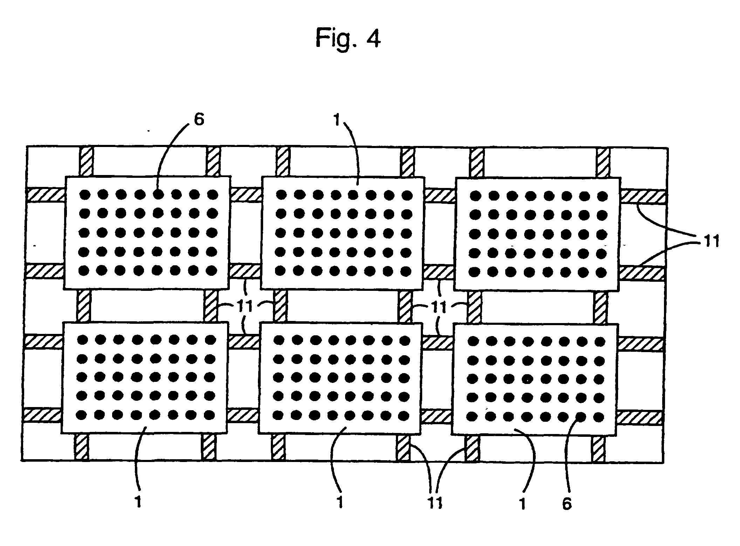

Fig. 4 zeigt ein Ausführungsbeispiel, bei dem eine Anordnung von mehreren Nadelkarten 1, die in einem als Versteifung 2 wirkenden festen Rahmen angebracht sind und lateral gegen diesen Rahmen bzw. gegen einander durch Piezoelemente 11 verschoben werden können.

Solche lateral wirkende Piezoelemente können ohne weiteres auch mit den vertikal wirkenden Piezoelementen der Fig. 1 und 3 kombiniert werden, wenn sie beispielsweise in Fig. 1 zwischen der Versteifung 2 und der Nadelkarte 1 in geeigneter Weise angebracht werden.

## Patentansprüche

1. Nadelkarten-Justageeinrichtung zur Planarisierung von Nadelsätzen (6) einer Nadelkarte (1) in bezug auf einen zu kontaktierenden Wafer (8), bei der die Nadelkarte (1) mit einer als Kontakt-Schnittstelle zu einem Testkopf (5) dienenden Platine (3) verbunden ist,
**dadurch gekennzeichnet, daß**
- die Nadelkarte (1) über eine gesonderte, dynamisch arbeitende Justageeinheit (4; 11) mit der Platine (3) -verbunden ist, und
- die Justageeinheit (4, 11) über eine Sense-Leitung (12) und eine Aktivleitung (13) mit einer Steuereinheit (14) verbunden sind.

2. Nadelkarten-Justageeinrichtung nach Anspruch 1,
**dadurch gekennzeichnet, daß**
die Justageeinheit aus wenigstens einem Piezoelement (11) aufgebaut ist.

3. Nadelkarten-Justageeinrichtung nach Anspruch 2,
**dadurch gekennzeichnet, daß**
die Justageeinheit eine Vielzahl von Piezoelementen (11) aufweist, die im Randbereich der Nadelkarte (1) an dieser angreifen.

4. Nadelkarten-Justageeinrichtung nach einem der Ansprüche 1 bis 3,
**dadurch gekennzeichnet, daß**
zwischen der Nadelkarte (1) und der Justageeinheit (11) zusätzlich eine Versteifung (2) vorgesehen ist.

5. Nadelkarten-Justageeinrichtung nach einem der Ansprüche 1 bis 4,
**dadurch gekennzeichnet, daß**
die Justageeinheit (4; 11) in Richtungen, die im wesentlichen senkrecht zu der durch die Nadelkarten-Oberfläche aufgespannten Ebene sind, und/oder in Richtungen, die im wesentlichen in dieser Ebene liegen, wirkt.

## Claims

1. Needle-card adjusting device for planarizing needle sets (6) on a needle card (1) in relation to a wafer (8) with which contact is to be made, in which the needle card (1) is connected to a circuit board (3) used as a contact interface to a test head (5), **characterized in that**
- the needle card (1) is connected to the circuit board (3) via a separate, dynamically operating adjusting unit (4; 11), and
- the adjusting unit (4, 11) is connected to a control unit (14) via a sense line (12) and an active line (13).

2. Needle-card adjusting device according to Claim 1, **characterized in that** the adjusting unit is constructed from at least one piezoelectric element (11).

3. Needle-card adjusting device according to Claim 2, **characterized in that** the adjusting unit has a multiplicity of piezoelectric elements (11), which act on the needle card (1) in the edge region thereof.

4. Needle-card adjusting device according to one of Claims 1 to 3, **characterized in that** a stiffening means (2) is additionally provided between the needle card (1) and the adjusting unit (11).

5. Needle-card adjusting device according to one of Claims 1 to 4, **characterized in that** the adjusting unit (4; 11) acts in directions which are essentially perpendicular to the plane covered by the needle-card surface and/or in directions which are essentially in this plane.

## Revendications

1. Dispositif de réglage de carte à pointes pour la planarisation de jeux (6) de pointes d'une carte (1) à pointes par rapport à une tranche (8) à contacter, dans lequel la carte (1) à pointes est reliée à une platine (3) servant d'interface de contact avec une tête (5) de test,
**caractérisé en ce que**
- la carte (1) à pointes est reliée à la platine (3) par une unité (4, 11) de réglage distincte fonctionnant de manière dynamique, et
- l'unité (4, 11) de réglage est reliée par une ligne (12) de détecteur et par une ligne (13) active à une unité (14) de commande.

2. Dispositif de réglage de carte à pointes suivant la revendication 1,
**caractérisé en ce que** l'unité de réglage est constituée d'au moins un élément (11) piézoélectrique.

3. Dispositif de réglage de carte à pointes suivant la revendication 2,
**caractérisé en ce que** l'unité de réglage a une pluralité d'éléments (12) piézoélectriques qui attaquent la carte (1) à pointes dans sa région de bord.

4. Dispositif de réglage de carte à pointes suivant l'une des revendications 1 à 3,
**caractérisé en ce qu'**il est prévu, en plus, un renfort (2) entre la carte (1) à pointe et l'unité (11) de réglage.

5. Dispositif de réglage de carte à pointes suivant l'une des revendications 1 à 4,
**caractérisé en ce que** l'unité (4, 11) de réglage agit dans des directions qui sont sensiblement perpendiculaires au plan passant par la surface de la carte à pointes et/ou dans des directions qui sont sensiblement dans ce plan.
